Europäisches Patentamt

European Patent Office

Office européen des brevets

(11) Publication number: **0 510 243 A2**

## EUROPEAN PATENT APPLICATION

(21) Application number: **91110080.8**

(22) Date of filing: **19.06.91**

(51) Int. Cl.5: **G11C 8/04**

(30) Priority: **22.04.91 US 689309**

(43) Date of publication of application:
**28.10.92 Bulletin 92/44**

(84) Designated Contracting States:
**DE GB IT**

(71) Applicant: **ACER INCORPORATED**
**7 Hsin-An Road**
**Hsin Chu Science-Based Industrial Park(TW)**

(72) Inventor: **Wan-Kan, Chan**
**P.O. Box 13658, 88841 Kota**
**Kinabalu, Sabah(MY)**

(74) Representative: **Liesegang, Roland, Dr.-Ing. et al**
**FORRESTER & BOEHMERT**
**Franz-Joseph-Strasse 38**
**W-8000 München 40(DE)**

(54) **Burst address sequence generator.**

(57) A kind of burst address sequence generator (10) is to generate $2^n$ pulse trains (n is an integer greater than 1) compatible with INTEL 80486 CPU, including the following: One n-bit binary up counter (11), whose input terminal inputs a signal of one first pulse train address (ZERO#) for initializing and to begin counting, and an increment signal (INC) used to trigger the input. The output terminal has n count signal $C(0, ..., n-1)$ to couple to n corresponding XOR gates (12); one transparent latch (13), whose input terminal inputs n address bit $A(m, ..., m+n-1)$ signals (in other words, $2^n$ pulse train burst cycles with size of each transmission data at $2^m$ bytes; $A_0 \sim A_{(M-1)}$ as the continuous lowest address of this $2^m$ bytes); one of the input signals and one latched act signal (ALE), the output is the n latched address signals $LA(m, ..., m+n-1)$, as well as n corresponding XOR gates coupled with the n count signals $C(0, ..., n-1)$ and n latched address signals LA in order to obtain n pulse train address signals $SA(m, ..., m+n-1)$. SA can be directly coupled to a static random access memory (SRAM). This invention also concerns a pulse train burst address sequence generator (20), with a delay reduction function to reduce the delay time of address generation by the above-mentioned pulse train burst address sequence generation.

Figure 5

EP 0 510 243 A2

A kind of burst address sequence generator (10) is to generate $2^n$ pulse trains (n is an integer greater than 1) compatible with INTEL 80486 CPU, including the following: One n-bit binary up counter (11), whose input terminal inputs a signal of one first pulse train address (ZERO#) for initializing and to begin counting, and an increment signal (INC) used to trigger the input. The output terminal has n count signal C(0, ..., n-1) to couple to n corresponding XOR gates (12); one transparent latch (13), whose input terminal inputs n address bit A-(m, ..., m+n-1) signals (in other words, $2^n$ pulse train burst cycles with size of each transmission data at $2^m$ bytes; $A_0 \sim A_{(M-1)}$ as the continuous lowest address of this $2^m$ bytes); one of the input signals and one latched act signal (ALE), the output is the n latched address signals LA(m, ..., m+n-1), as well as n corresponding XOR gates coupled with the n count signals C(0, ..., n-1) and n latched address signals LA in order to obtain n pulse train address signals SA(m, ..., m+n-1). SA can be directly coupled to a static random access memory (SRAM). This invention also concerns a pulse train burst address sequence generator (20), with a delay reduction function to reduce the delay time of address generation by the above-mentioned pulse train burst address sequence generation.

Generally, the pulse train burst address sequence of a central processing unit (CPU) of the INTEL 80486 is decided by the starting address; the customary technique involves using the clock state machine and based on the value of the starting address to decide the sequence of state transfer. To generate $2^n$ pulse train addresses, at least $(2^n)+1$ states and n outputs are required. If the state machine is a programmable array logic (PAL) or a programmable logic device (PLD) to execute, then $(n+1)+n$ register outputs are required as $(2^n)+1$ states in a state machine and n register outputs for n bits of pulse train addresses.

When n = 2, four pulse train burst cycles should have at least have 2 + 1 + 2 = 5 register outputs. Or, when n = 3 (as in the case of write back cache of INTEL apogee module), eight pulse train burst cycles can be made for at least 3 + 1 + 3 = 7 register outputs. In this situation, generally there are only eight inputs used for the device of the state machine (such as PAL or PLD with 20 or 24 pins); therefore, a single PAL or PLD can accomplish the task.

When n = 4 (at present, it is not available at INTEL), however, based on design considerations of the system, it is possible to divide a 128-bit pulse train into two 64-bit pulse trains; thus, eight 128-bit pulse train burst cycles will become 16 pulse train burst cycles; then at least there should be 4 + 1 + 4 = 9 register outputs. At that time, the design can only be completed by adding 1 PAL or 1 PLD.

In conclusion, for each increment of 1 in n, requirements in register outputs should be incremented by at least two registers. With this approach, the following problems will exist: (1) the PAL or the PLD should be increased for execution; (2) owing to the lack of the expandable feature, the state machine should be completely redesigned; (3) debugging should be re-executed, among other problems.

This patent aims to provide a pulse train address sequence generator which can be randomly expanded. The generator has the following functions and effects.

1. This is low in price, composed of conventional transistor-transistor logic (TTL) elements.

2. The circuitry is simple and reliable.

3. Expansion can be randomly carried out to support $2^n$ pulse train sequences.

4. During expansion, no circuits may be changed by only repeatedly using the identical elements without redesigning the circuit or debugging.

Explanations of the appended figures:

Fig. 1 is a block diagram of the conventional pulse train address sequence generating device.

Fig. 2 is a schematic diagram for the address bits in genrating $2^n$ pulse train addresses.

Fig. 3 is a schematic diagram for generally producing the sequence of the pulse train address compatible with the CPU of the INTEL 80486 series.

Fig. 4 is a schematic diagram for binary state of the starting address based on the identified pulse train sequence of this patent.

Fig. 5 is a block diagram of the pulse train address sequence generating device based on this patent.

Fig. 6 is a block diagram explaining the reduction in delay (based on this patent) of the pulse train address sequence generating device.

Fig. 7 is the timing diagram in coordination with Fig. 6 based on this patent.

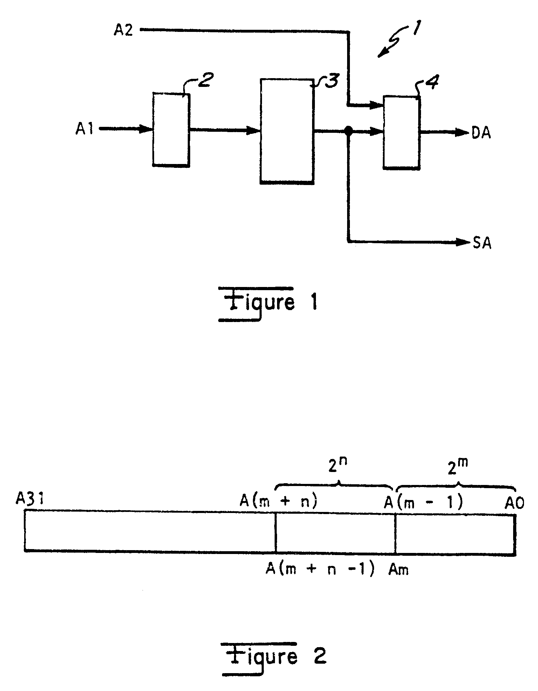

In the conventional pulse train address sequence generating device (1), in Fig. 1 one first address signal (such as column signal) $A_1$ is transmitted to a timing state machine (3) after being latched with a latch device (2) in order to follow a certain sequence to generate the required pulse train address signal (SA). Capable of being used directly as the static random access memory (SRAM), the address signal can also be transmitted (along with one second address signal, such as row signal) to a multiplexer (4) in order to obtain an address signal (MA) of a dynamic random access memory (DRAM). When the number n of the pulse train address is incremented, the above-mentioned problem will exist.

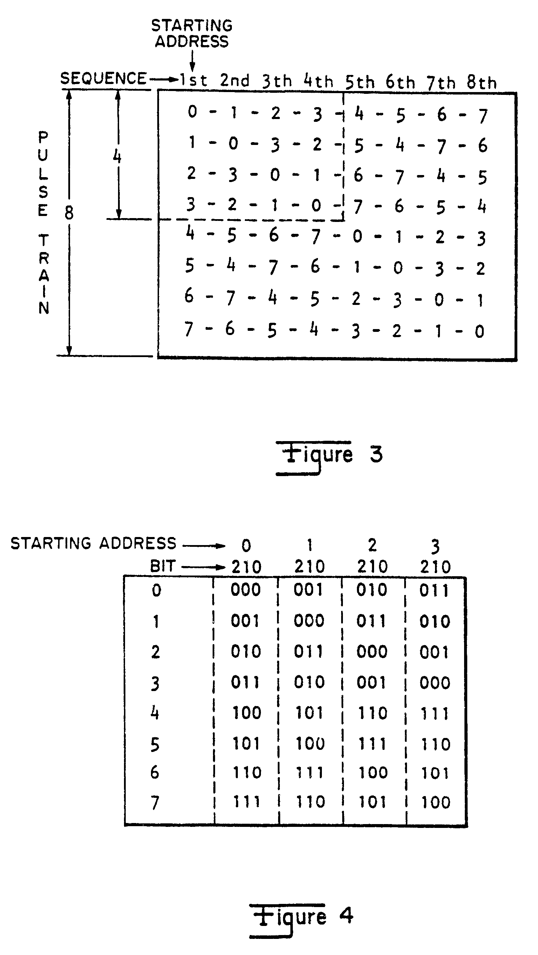

In the schematic diagram of the address bits as in Fig. 2, $2^m$ bytes are used as the fundamental transmission unit of a circuit to generate $2^n$ pulse train burst cycles; the circuit should generate $2^n$ pulse train addresses; however, the form of the address bits is shown in the figure. A0 and A1 can possibly appear in the form of BE0#-BE3#. In the case of the INTEL 80486 CPU, the fundamental unit in transmitting each pulse train is 4 bytes ($m = 2$); however, mostly four burst cycles can be conducted. Therefore, the circuit should generate two burst addresses of A2 and A3. In order to generate pulse train address sequences compatible with INTEL 80486 series CPU, the pulse train address A(m, ..., m+n-1) should follow the sequence determined by the attached table in Fig. 3. Each pulse train sequence should be decided only by the first address, that is, the starting address. In the case of 486, the sequence of four pulse trains is the same as the sequence in the left upper corner and in the internal box.

In Fig. 4, the working principle of this patent is based on the sequence in the attached table in Fig. 3. By citing an example in which the starting address is composed of four sets of pulse train address sequences of 0, 1, 2 and 3, the sequence can be obtained by rewriting in binary form. By carefully observing the binary form diagram, it can be discovered that the binary sequence with the starting address as 0 is actually an evolution of a binary up counting. On viewing the other binary sequence, it can be discovered that the i-th ($i = 0$, ..., n-1) bit of j ($j = 0, 1, ..., 2^n-1$) pulse trains, and the i-th bit of binary value with the j-th starting address as 0 should simultaneously change the values (that is, O 1). However, for each sequence,

for the value of bit 0, there is one phase reversal for each increment in 1 in the count;

for the value of bit 1, there is one phase reversal for each increment in 2 in the count; and

for the value of bit n-1, there is one phase reversal for each increment in $2^{n-1}$ in the count.

From this observation, one up counting of the binary up counter can be used to tell at what time the phase reversal should occur for various bits in a sequence with a time base.

Aincrement, carefully observe Fig. 4; it can be discovered that besides the simultaneous state conversion of the binary bit count for bit i in the sequence other than using 0 as the starting address, the change into 1 or 0 should be determined by the bit i of the starting address.

If the value of the bit i of the starting address is 1, then the value of bit i is just reversed to the value of bit i in the converting and corresponding binary counter in the j pulse train.

Conversely, if the value of the starting address bit i is 0, then the value of bit i is the same as the value of bit i in the corresponding binary counter. In other words, the values change simultaneously into 1 or 0. This means that the value of bit i in j pulse trains (represented as Ai and j) and its relationship with an XOR gate for bit i (expressed as Ci, j) of count j in the binary counter can be expressed as $: + :$. In other words, Ai, j = Ci, j: + :Ai,0.... Formula (1). In the formula, Ai, 0 is the starting address.

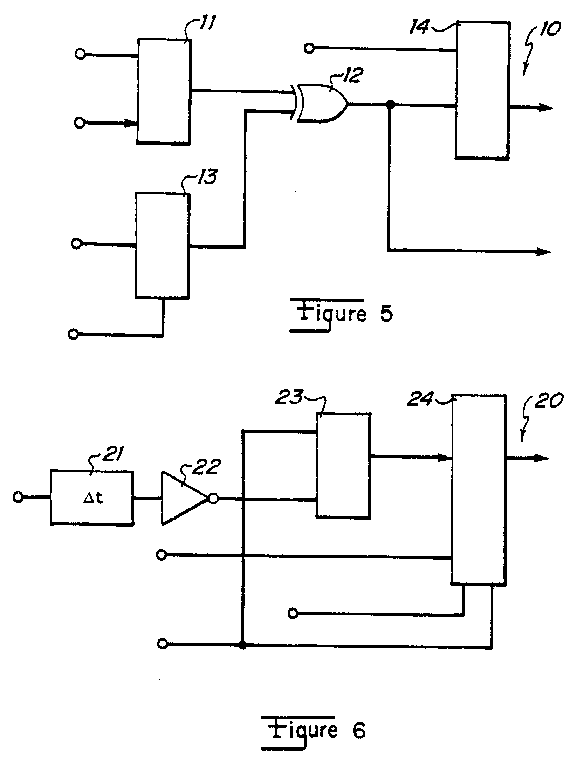

Based on formula (1), the logic circuit shown in Fig. 5 can be directly designed. Then SA(m+j)- = LA(m+j): + :C(j)... Formula (2); in the formula, $j = 0, ..., n-1$; LA is the latched starting address A; SA is the pulse train address. Formula (2) shows the method of conecting the individual XOR in a particular circuit. If $2^n$ is required, there should be one n bit binary up counter and n XOR gates.

In Fig. 5, the pulse train burst address sequence generator (10) is used to generate $2^n$ pulse train address sequences (n is an integer greater than or equal to 1), including the following: one n-bit binary up counter (11), whose input terminal inputs increment signal (INC) used for initializing and to begin counting in order to generate a signal (ZERO#) of the first pulse train address, and an increment signal (INC) for triggering the input. The output terminal is n count signals C(0, 1, ..., n-1) to couple and connect to the n corresponding XOR gates (12); one transparent latch (13), the input terminal inputs one of the n address bits A(m, ..., m+n-1) signals (in other words, the size of each transmitted data is $2^m$ bytes for $2^n$ pulse train burst cycles; $A_1 \sim A_{M-1}$ is the continuous lowest address of this $2^m$ bytes) and one latched act signal (ALE). However, the output is the n latched address signals LA(m, ..., m+n-1), as well as n count signals C(0, 1, ..., n-1) and n latched address signals LA(m, ..., m+n-1) to be coupled to the n corresponding XOR gates. A(m, ..., m+n-1) is the starting address; after the transparent latch locks A, A(m, ..., m+n-1) can be randomly varied. If the starting address does not change in the entire cycle of pulse train transmission, this transparent latch (13) is not necessary, but can be replaced with A(m, ..., m+n-1) for LA(m, ..., m+n-1) to be directly coupled to the n-th corresponding XOR gate in order to obtain n pulse train address signals SA(m, ..., m+n-1) to be directly coupled to a static random access memory (SRAM) or a multiplexer (14) to become an address signal of the dynamic memory (DRAM).

Since the XOR gate and the multiplexer in Fig. 5 have two levels of delay, in order to reduce to one delay level, a module of a dynamic random access memory (DRAM) is used to change Fig. 5 into the circuit as in Fig. 6.

As shown in Fig. 6, this is a pulse train sequence generating device (20) capable of reducing the delay in generating the pulse train address, including the following: one delay unit (21) to be used in delay time $\Delta t$ for the CAS# (CAS# is the signal of capturing the column address for access of data of dynamic RAM); however, $\Delta t > t_{cah}$ ($t_{cah}$ is the retaining time after changing act at CAS# for the column address); one phase inverter (22) to be used in phase reversal and coupling the delay CAS# to a counter (23) to make an increment for the counter; another input terminal of the counter (23) couples for initializing and to begin counting in order to generate a signal ALE of the first pulse train address; the output terminal is n counting signals C(0, 1, ..., n-1). In addition, n corresponding latching, multiplexing and XOR gates (24) can be one PAL or one PLD; each input terminal is coupled with a corresponding counting cycle, a corresponding address signal A(m, ..., m+n-1), a corresponding row address RA(0, 1, ..., n-1), and one multiplexer multiplexing selection signal Mux to be used to select the address of the dynamic memory as column or row address. In addition, there is an address latched act signal (ALE), whose output is address MA(0, ..., n-1) of the dynamic memory; when the ALE is of high value (or low value), the A address signal is locked into a latched signal LA- (totalling 0, 1, ..., n-1) in n corresponding LA signals; however, when the LA signal is a low value (or high value), the A address signal is transparent to become MA signal (totalling n corresponding signals (0, 1, ..., n-1)). In the pulse train address sequence generator (20), in addition to executing the latch function in the logic device PAL or PLD, there should be functions of XOR gate and multiplexer to be used in executing the function corresponding to (13), (12) and (14) in Fig. 5. The following are the computations:

$$MA(i) = Mux \bullet RA(i) + /Mux \bullet A(m+i) \bullet /ALE + /Mux \bullet [LA(m+1): + :C(i)] \bullet ALE \qquad (3)$$

In the formula, LA(m+i) is the latched address signal A(m+i), and RA(i) is the corresponding row address; A(m+i) is the starting address.
"+" is OR logic,
"•" is AND logic,
":+:" is XOR logic,
Mux is the multiplexing selection signal,
/ALE is the phase reverse ALE signal, and
/Mux is the phase reversed Mux.

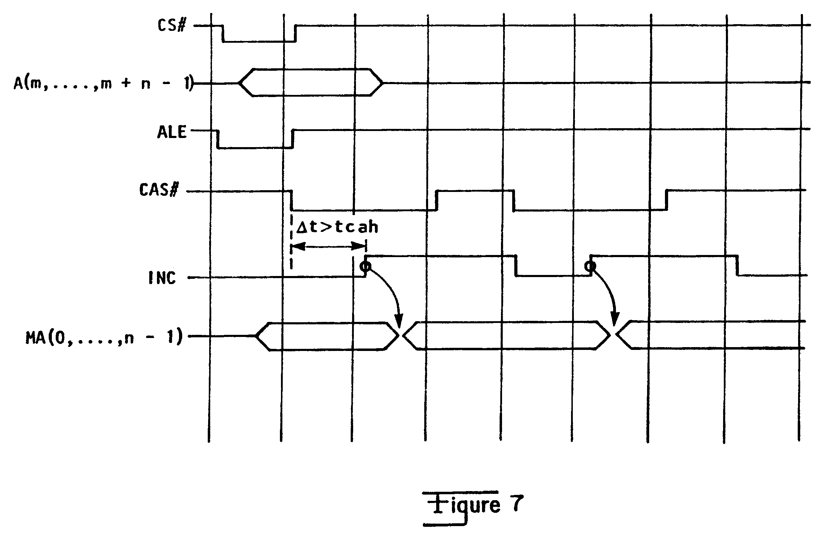

The timing at the operation in Fig. 6 is shown in Fig. 7. In Fig. 7, CS# (CYCLE START) is a transmitting cycle start signal; when the signal is at a low value, the starting address A will be transmitted. As CS#, ALE becomes a low value at the same time. At this time, the counter should reset to be initialized because each pulse train transmission should begin from the starting address from 0 relative to the C value. When ALE is LOW, the counter is cleared. In addition, from formula (3), we know if the Mux signal is a low value, MA is A. In other words, at that time A is transparent to MA because the MA generated time will not satisfy the address access time (tAA) of SRAM if executing with the direct logic of C: + :A = MA; the reason is that the time is too long from ALE to clear C to zero in counting. For each increment of the counter, based on formula (1) an instruction is given to the XOR logic to generate a pulse train address; however, the counter generates increments (INC) as the increment trigger of the counter with delayed CAS# before phase reversal. Thus, when completing one transmission of pulse train data, the CAS# completes a cycle from high value to low value and increment returns to high value; the counter then automatically has an increment of one.

**Claims**

1.  A pulse train burst sequence generator (10) is to generate $2^n$ pulse train address sequences (n is an integer greater than 1), including the following: one n-bit binary up counter (11); the input terminal inputs signal ZERO# of a burst pulse train address used to initialize and to begin counting, and one increment signal INC for triggering the input; the output terminal is n count signals C(0, ..., n-1) to couple and connect to an input terminal of the n corresponding XOR gates (12). In addition, the starting address signal A(m, ..., m+n-1) (in other words, the size of each transmitted data of $2^n$ pulse train burst cycles is $2^m$ bytes; $A_0 \sim A_{m-1}$ is the continuous lowest address of these $2^m$ bytes) is coupled to another input terminal of the n corresponding XOR gates in order to obtain n pulse train address signals SA(m, ..., m+n-1).

2.  Based on the pulse train address sequence generating device in item 1 of the patent coverage, the XOR gates (12) execute the following computation:

    $$SA(m+j) = A(m+j): + :C(j)$$

    In the equation, SA(m+j) is the (m+j)-th pulse train address signal.
    A(m+j) is the starting address signal of the (m+j)-th item.
    C(j) is the j-th count signal.
    The rejection or XOR logic of : + :, and i = 0, ..., n-1.

**3.** According to the pulse train sequence generating device (burst address sequence generator) in item 1 of the patent coverage, it includes one multiplexer (14), which is used to multiplex the n pulse train address signals SA(m, ..., m + n-1) to become the column address signal and another inputted n row address signals as outputting from the XOR gate (12). Thus, the address signals MA(0, ..., n-1) of n dynamic memories are obtained.

**4.** A kind of pulse train burst address sequence generator (10) is used to generate $2^n$ pulse train address sequences (n is an integer greater than 1), including the following: one n-bit binary up counter (11), whose input terminal inputs signal ZERO# of the first pulse train address for initializing and to begin counting, and an increment signal (INC) for triggering the input; the output terminal of the binary up counter is n count signals C(0, ..., n-1) to couple and connect to an input of the n-th corresponding XOR gate (12), and a transparent latch (13), whose input terminal inputs one of n signals of the starting address bit A(m, ..., m + n-1) (that is, the size of each transmitted data of $2^n$ pulse train burst cycles is $2^m$ bytes; $A_0 \sim A_{m-1}$ is the continuous lowest address of this $2^m$ bytes) and a latched act signal (ALE); however, the output is the n latched starting address signals LA(m, ..., m + n-1) and LA(m, ..., m + n-1) to be coupled to another input terminal of the n corresponding XOR gates in order to obtain n pulse train address signals SA(m, ..., m + n-1).

**5.** Based on item 4 in the patent coverage, the XOR gate (12) executes the following computations:

$$SA(m + j) = LA(m + j) : + : C(j)$$

In the equation, SA(m + j) is the (m + j)-th pulse train address signal;
LA(m + j) is the (m + j)-th latched starting address signal;
C(j) is the count signal of the j-th item;
": + :" is the rejection or XOR logic;
and i = 0, ..., n-1.

**6.** According to the pulse train burst address sequence generator in item 4 of the patent coverage, it includes a multiplexer (14), which is used to multiplex the n pulse train address signals SA(m, ..., m + n-1) (outputted from the XOR gate (12)), thus forming the column address signal and another inputted n row address signals in order to obtain n address signals MA(0, ..., n-1) of the dynamic memory device.

**7.** A pulse train address sequence generator (20) for reducing delay, including one delay apparatus (21) to be used to delay $\Delta t$ time of one CAS# signal in input; $\Delta t > t_{cah}$ ($t_{cah}$ is the retaining time of the column address after the CAS# is low in value);

One phase inverter (22), which is used to couple the delayed CAS# signal to trigger input to a counter (23) for incrementing;

Another input terminal of the counter (23) couples and connects a signal ZERO# of the first pulse train address generated for initializing and for counting to begin; the output terminal is the n count signals C(0, ..., n-1); and

n corresponding latched, multiplexing and XOR gates (24), the input terminal of each one couples and connects to a corresponding count signal C(0, ..., n-1), one corresponding address signal A(m, ..., m + n-1), one corresponding row address (totalling n in number), one multiplexing selection signal Mux, and one address latched act (ALE) signal to be used for the ALE signal; when the signal at the first value, the A(m, ..., m + n-1) address signal is latched into a latched signal LA(m, ..., m + n-1) (totalling, there are n (0, 1, ..., n-1) corresponding LA signals); when the ALE signal is at a second low value, then the A(m, ..., m + n + 1) address signal is transparent to signal MA(0, ..., n-1) (again, there is a total of n(0, 1, ..., n-1) corresponding MA signals); however, when the first value is a high value, the second value is low. However, when the first value is a low value, the second value is a high value.

**8.** According to the pulse train address sequence generating device (20) in item 7 of the patent coverage, the latched, multiplexing and XOR gates (24) are used to execute the following computations:

$$MA(i) = Mux \bullet RA(i)$$
$$+ /Mux \bullet A(m + 1) \bullet /ALE$$
$$+ /Mux \bullet [LA(m + i) : + : C(i)] \bullet ALE$$

In the equation, LA (m + i) is the latched starting address A(m + i);
Mux is the multiplexing selection signal;
/ALE is the phase reversal ALE signal;
RA(i) is the corresponding row address signal;
/Mux is the phase reversal Mux signal;
"$\bullet$" is AND logic;
"+" is OR logic;
": + :" is the rejection or XOR logic.

9. According to the pulse train address sequence generating device (20) in item 7 of the patent coverage, the latched multiplexing XOR gate (24) is a programmable array logic (PAL).

10. According to the pulse train address sequence generating device (20) in item 7 of the patent coverage, the latched multiplexing XOR gate (24) is a programmable logic device (PLD).

Figure 1

Figure 2

STARTING
ADDRESS
↓

SEQUENCE →1st 2nd 3th 4th 5th 6th 7th 8th

```
P      |  0 - 1 - 2 - 3 ⌐ 4 - 5 - 6 - 7
U      |  1 - 0 - 3 - 2 ⌐ 5 - 4 - 7 - 6
L   4  |  2 - 3 - 0 - 1 ⌐ 6 - 7 - 4 - 5
S      |  3 - 2 - 1 - 0 ⌐ 7 - 6 - 5 - 4
E   8     4 - 5 - 6 - 7 - 0 - 1 - 2 - 3
T         5 - 4 - 7 - 6 - 1 - 0 - 3 - 2
R         6 - 7 - 4 - 5 - 2 - 3 - 0 - 1
A         7 - 6 - 5 - 4 - 3 - 2 - 1 - 0
I
N
```

Figure 3

| STARTING ADDRESS → | 0 | 1 | 2 | 3 |
|---|---|---|---|---|
| BIT → | 210 | 210 | 210 | 210 |
| 0 | 000 | 001 | 010 | 011 |
| 1 | 001 | 000 | 011 | 010 |
| 2 | 010 | 011 | 000 | 001 |
| 3 | 011 | 010 | 001 | 000 |
| 4 | 100 | 101 | 110 | 111 |
| 5 | 101 | 100 | 111 | 110 |
| 6 | 110 | 111 | 100 | 101 |
| 7 | 111 | 110 | 101 | 100 |

Figure 4

8

Figure 5

Figure 6

Figure 7